# EUROPEAN PATENT APPLICATION

(11) **EP 2 819 176 A1**
(43) Date of publication of application: **31.12.2014**
(21) Application number: 12867761.4
(22) Date of filing: 15.08.2012
(51) Int. Cl.: H01L 31/042

(54) **FLEXIBLE EFFICIENT SOLAR CELL PANEL**

(30) Priority: 10.02.2012 CN 201220043335 U
(71) Applicant: Shenzhen Sacred Solar Technology Co. Ltd., Shenzhen, Guangdong 518000 (CN)
(72) Inventor: WEI, Haigui, Shenzhen Guangdong 518000 (CN); HUANG, Dongli, Shenzhen Guangdong 518000 (CN)
(74) Representative: Jeannet, Olivier
(86) International application number: PCT/CN2012/080137
(87) International publication number: WO 2013/117084

(57) **Abstract**

Provided is a flexible efficient solar cell panel, comprising a flexible substrate (5), a solar assembly (3) and a transparent protective layer (1); the flexible substrate (5) can bend in an arc-shape and is used to bear the solar assembly (3); the platy solar assembly (3) is formed by serially connecting a plurality of solar cell slices bendable in an arc-shape, and the solar assembly (3) is fixed on the substrate (5); the transparent protective layer fixedly covers the surface of the solar assembly (3) and is used to protect the solar assembly (3). The flexible solar cell panel can bend in an arc-shape with a maximum angle of 60 degrees, and because of the flexibility, can be used on the roof of vehicles such as electric golf cars, patrol cars, sightseeing cars and the like, and can also be used in the fields of yachts, arc-shaped roofs, backpack tents and the like.

## Description

### Technical Field

The disclosure relates to a solar cell panel, and in particular, to an efficiency solar cell panel capable of being bent along an arc shape.

### Background Art

Solar energy, as inexhaustible new clean energy, has been widely applied in the fields of industry, farmer, scientific research and education, and the like. Solar power generation is one of the most widely-applied forms of solar energy, while a solar cell panel is a key constituent part of the solar power generation. The solar cell panel in the prior art generally comprises a planar substrate, a solar cell panel and a transparent glass panel. The solar cell panel is fixed between the substrate and the transparent glass panel. The solar cell panel having such a structure can only be installed in a planar manner, so that the application of the solar cell panel is limited greatly.

### Summary of the Invention

To overcome the defects of the prior art, the disclosure provides a solar cell panel, capable of being bent along an arc shape, having a larger light energy conversion area, and capable of being flexibly applied in the fields of arc-shaped car roofs, arc-shaped house roofs, knapsacks and tents that have cambered surface. Moreover, because of the selection of higher efficient flexible solar cell pieces, the photoelectric conversion efficiency of the solar cell panel of the disclosure is higher.

To achieve the above-mentioned object, the disclosure uses the following technical solution.

A flexible efficient solar cell panel includes a flexible substrate, a solar assembly, and a transparent protective layer. The flexible substrate is bend in an arc-shape to bear the solar assembly. The solar assembly is formed by serially connecting a plurality of solar cell slices bendable in an arc-shape and fixed on the substrate. A transparent protective layer fixedly covers a surface of the solar assembly to protect the solar assembly.

The flexible efficient solar cell panel includes a fixed adhesive layer between the flexible substrate and the solar assembly to fix the solar assembly on the substrate.

The flexible efficient solar cell panel includes a transparent fixed adhesive layer between the transparent protective layer and the solar assembly to fix the transparent protective layer on the solar assembly.

The flexible substrate is made of a TPT (polyvinyl fluoride composite film) panel and the transparent protective layer is made of a PET (polyethylene terephthalate) thin film.

The fixed adhesive layer is an EVA (copolymer of ethylene and vinyl acetate) fixed adhesive layer.

The transparent fixed adhesive layer is an EVA (copolymer of ethylene and vinyl acetate) transparent fixed adhesive layer.

Because of the adoption of the above-mentioned solution, the flexible efficient solar cell panel of the disclosure can bend in an arc shape with a maximum angle of 60 degrees. Furthermore, a photoelectric efficiency of the flexible efficient solar cell panel of the disclosure is 22% which is the maximum efficiency at current. In addition, because of the flexibility, the flexible efficient solar cell panel can be used on the roof of electric golf cars, patrol cars and sightseeing cars and the like, and can also be used in the fields of yachts, arc-shaped roofs or even knapsacks and tents, as well as exceeds the application limit of a planar solar cell panel.

### Brief description of the drawings

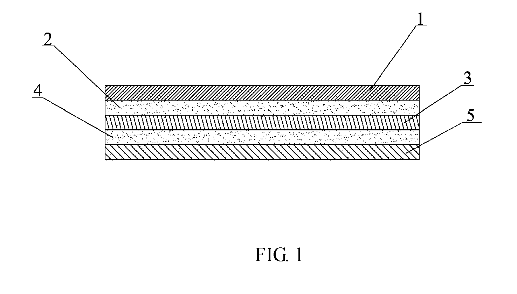

FIG. 1 is a schematic sectional diagram of the disclosure.

### Detailed Description

The disclosure is further described in details hereinafter with references to the attached drawings and specific embodiments.

As shown in FIG. 1, a flexible efficient solar cell panel includes a flexible substrate 5, a flexible efficient solar cell component 3 and a transparent protective layer 1. The flexible substrate 5 may be bent along an arc shape at a maximum bending angle of 60 degrees. The efficient solar cell component 3 is borne on the flexible substrate 5. The transparent protective layer 1 covers the efficient solar cell component 3. A fixed adhesive layer 4 is arranged between the flexible substrate 5 and the efficient solar cell component 3, so that the solar cell component 3 may be thermoset on the substrate 5. At the same time, a transparent fixed adhesive layer 2 is arranged between the solar assembly 3 and the transparent protective layer 1, so that the transparent protective layer 1 may be thermoset on the solar assembly 3.

As a preferred solution, solar cell pieces produced by American Sunpower Corporation are selected for the flexible efficient solar cell component of by the disclosure. The photoelectric conversion efficiency of the cell pieces may be 22%. The solar cell component of the disclosure is formed by serially connecting the solar cell pieces produced by the corporation. Simultaneously, the substrate 5 is made of a TPT (polyvinyl fluoride composite film) panel, having an excellent bending performance. The transparent protective layer 1 is made of a PET (polyethylene terephthalate) thin film, having an extremely high light transmission performance. Both the fixed adhesive layer 2 and the fixed adhesive layer 4 are EVA (copolymer of ethylene and vinyl acetate) fixed adhesive layers.

The foregoing is merely one embodiment of the disclosure. It is possible for anyone to make changes or alterations on the design without departing from the protection scope of the disclosure. However, it should be understood that these changes and alternations shall still pertain to the protection scope of the disclosure.

## Claims

1. A flexible efficient solar cell panel, comprising:
a flexible substrate;
a solar assembly formed by serially connecting a plurality of solar cell slices bendable in an arc-shape and fixed on the substrate; and
a transparent protective layer fixedly covering a surface of the solar assembly to protect the solar assembly;
wherein the flexible substrate is bend in an arc-shape to bear the solar assembly.

2. The flexible efficient solar cell panel of claim 1, wherein the flexible efficient solar cell panel comprises a fixed adhesive layer between the flexible substrate and the solar assembly to fix the solar assembly on the substrate.

3. The flexible efficient solar cell panel of claim 1 or 2, wherein the flexible efficient solar cell panel comprises a transparent fixed adhesive layer between the transparent protective layer and the solar assembly to fix the transparent protective layer on the solar assembly.

4. The flexible efficient solar cell panel of claim 1, wherein the flexible substrate is made of a TPT (polyvinyl fluoride composite film) panel and the transparent protective layer is made of a PET (polyethylene terephthalate) thin film.

5. The flexible efficient solar cell panel of claim 2, wherein the fixed adhesive layer is an EVA (copolymer of ethylene and vinyl acetate) fixed adhesive layer.

6. The flexible efficient solar cell panel of claim 3, wherein the transparent fixed adhesive layer is an EVA (copolymer of ethylene and vinyl acetate) transparent fixed adhesive layer.
